# EUROPEAN PATENT APPLICATION

(11) **EP 2 533 034 A1**
(43) Date of publication of application: **12.12.2012**
(21) Application number: 11305736.8
(22) Date of filing: 10.06.2011
(51) Int. Cl.: G01N 24/12, G01R 33/62

(54) **DNP NMR spectroscopy with non-aqueous solvents**

(71) Applicant: Bruker Biospin SA, 67160 Wissembourg (FR); Eidgenössische Technische Hochschule Zürich, 8092 Zürich (CH); Ecole Normale Supérieure de Lyon, 69007 Lyon (FR); Université Claude Bernard Lyon I, 69100 Villeurbanne (FR); Centre National de la Recherche Scientifique (Etablissement Public à Caractère Scientifique, et Technologique), 75016 Paris (FR); Université d'Aix-Marseille, 13007 Marseille (FR)
(72) Inventor: Maas, Werner, Merrimac, MA 01860 (US); Rosay, Melanie, Bedford, MA 01730 (US); Coperet, Christophe, 8037 Zürich (CH); Gajan, David, 69100 Villeubanne (FR); Emsley, Lyndon, 38950 Saint Martin le Vinoux (FR)
(74) Representative: Nuss, Laurent

(57) **Abstract**

The present invention concerns a method to determine the efficiency of a solvent to impregnate a sample material for use in a dynamic nuclear polarization (DNP) nuclear magnetic resonance (NMR) experiments, characterized in that the method comprising:
- selecting a non-aqueous solvent,
- providing a polarizing agent that is soluble in the non-aqueous solvent,
- dissolving the polarizing agent in the non-aqueous solvent,
- impregnating or dissolving the sample material with the non-aqueous solvent containing the polarizing agent,
- performing a solid state DNP NMR experiment on the impregnated sample material,
- determining a DNP enhancement factor of the DNP NMR experiment.

## Description

The invention relates in particular to mixtures for Dynamic Nuclear Polarization (DNP) NMR Spectroscopy.

The present invention concerns more specifically the development of non aqueous mixtures for DNP NMR Spectroscopy.

DNP experiments are usually performed by saturating the electron spin transition using continuous-wave (CW) irradiation at low temperature (150 K or below). The first DNP experiments were carried out at low magnetic field, but due to the lack of microwave sources operating at high frequency (Terahertz), this technique was of limited applicability. Today, DNP has become a valuable method in the field of structure analysis by high resolution solid-state NMR Spectroscopy at high magnetic fields.

During a DNP experiment, polarization transfer between electrons and nuclei can occur at low temperature via electron-nuclear coupling mechanisms. A part of the efficiency of this polarization transfer depends on the polarizing agent and the type of solvent used for the DNP experiment. It is known and demonstrated that the use of biradicals, such as TOTAPOL or bTbK, can provide a large DNP enhancement at high magnetic fields.

Commonly, solvents used for these biradicals are mixtures based on water. However, some materials are air and moisture sensitive and wetting and/or dissolution by classical aqueous solvent mixtures containing the polarizing agent may degrade the materials under study. Furthermore, many polarizing agents are not compatible with aqueous solvents.

It is a main aim of the present invention to overcome the aforementioned disadvantages and to provide a solution adapted to air and moisture sensitive materials and to polarizing agent allowing for the study of such materials with DNP NMR Spectroscopy.

Therefore, the main object of the present invention is a method to determine the efficiency of a solvent to impregnate or dissolve a sample material for use in a dynamic nuclear polarization (DNP) nuclear magnetic resonance (NMR) experiment, characterized in that the method comprises:
- selecting a non-aqueous solvent,
- providing a polarizing agent that is soluble in the non-aqueous solvent,
- dissolving the polarizing agent in the non-aqueous solvent,
- impregnating or dissolving the sample material with the non-aqueous solvent containing the polarizing agent,
- performing a DNP NMR experiment on the impregnated sample material,
- determining a DNP enhancement factor of the DNP NMR experiment.

The invention also concerns a method to obtain a DNP-enhanced NMR spectrum of a sample material, characterized in that the method comprises:
- using a mixture of a solvent and a polarizing agent,
- selecting a non-aqueous solvent,
- providing a polarizing agent that is soluble in the non-aqueous solvent,
- dissolving the polarizing agent in the non-aqueous solvent,
- impregnating or dissolving the sample material with the non-aqueous solvent containing the polarizing agent,
- performing a DNP NMR experiment on the impregnated sample material.

Further the invention concerns a method of use of a mixture of a non-aqueous solvent and a polarizing agent that is soluble in the non-aqueous solvent to impregnate or dissolve a sample material in order to perform a dynamic nuclear polarization (DNP) nuclear magnetic resonance (NMR) experiment characterized in that the DNP NMR is performed by a method according to the invention on said impregnated or dissolved sample.

The invention will be better understood thanks to the following description and drawings of different embodiments of said invention given as non limitative examples thereof, wherein:
- Figure 1 illustrates the structure of a model hybrid material (compound **I**) used as an example of the method of determination of the invention;
- Figure 2a and Figure 2b respectively illustrates the Molecular structure of the bTbK biradical and of the TOTAPOL biradical;
- Figure 3 illustrates a proton spectrum microwave on (upper trace wave: 16 scans, 6 s recycle delay) and off (lower trace wave: 16 scans, 6 s recycle delay) of **I** wetted with a 10.8 mM solution of bTbK in tetrachloroethane;
- Figure 4 illustrates ¹H-²⁹Si CP spectra obtained with microwave on (upper trace wave: 2500 µs contact time, 32 scans, 2 seconds recycle delay) and off (lower trace wave: 2500 µs contact time, 64 scans, 2 seconds recycle delay) of compound **I** wetted with a 10.8 mM solution of bTbK in tetrachloroethane;
- Figure 5 illustrates the DNP enhancement factor of various non-aqueous solvent bi-radical mixtures. Proton and silicon enhancement for compound **I** wetted with a 10 mM solution of bTbK in different solvents, wherein the ¹H spectra were recorded by direct excitation with 8 scans and an interval of 1s between each scan and wherein the ²⁹Si spectra were recorded using ¹H-²⁹Si (CP) in 512 scans, with a 1s recycle delay;
- Figure 6 illustrates the silicon enhancement (ε) and effective sensitivity enhancement excluding (Σ_{LT}) or including (Σ) the Boltzmann factor observed on compound **I** as a function of radical concentration. The MW on ¹H-²⁹Si CP spectra for the measurement of *ε* were acquired with 32 scans, while the MW off spectra were recorded with 64 scans, both with a 2 s delay between scans. Σ and Σ_{LT} were calculated from two spectra acquired with (4 scans, MW on) and without (128 scans) the radical, on compound **I** both using a 35 s delay between each scan to ensure full relaxation;

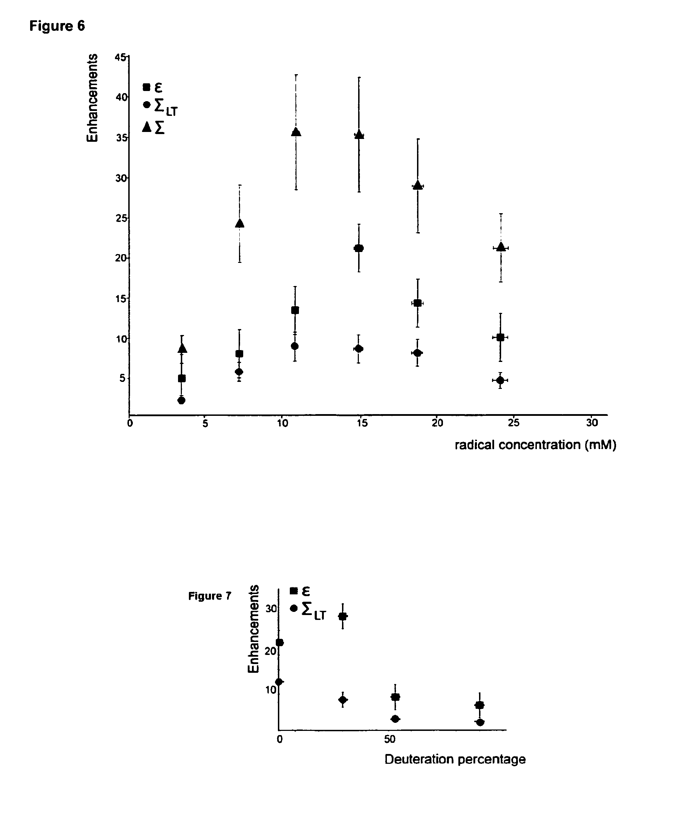

- Figure 7 illustrates the silicon enhancement (ε) and effective sensitivity enhancement not taking into account the Boltzmann factor (Σ_{LT}) as a function of the deuteration percentage of the solvent (solution of 14 mM bTbK in tetrachloroethane); The MW on ¹H-²⁹Si CP spectra for the measure of ε were acquired using with 32 scans, and the microwaves off spectra with 64 scans; with a 2s delay between each spectra. Σ_{LT} was measured using 4 scans for the microwave on spectra and 128 scans for spectrum of the material wetted with pure solvent, with a 35 second delay between each scan to ensure full relaxation; (T= 102 K, B₀ =9.4 T, ω_{H}/2π =400 MHz, ω_{Si}/2π = 79.5MHz, ω_{R}/2π =8 kH).
- Figure 8a shows an ¹H-¹³C CP MAS spectra of YDEAS with MW irradiation at 263 GHz to induce DNP; the sample was wetted with 10.2 mM bTbK solution in tetrachloroethane;
- Figure 8b shows a contour plot of a two-dimensional ¹H-¹³C spectrum of YDEAS wetted with the same solution of bTbK recorded with DNP using MW irradiation at 263 GHz; a proton enhancement of 18 was obtained for this compound.

In the present document, the expression "solvent" is not limited to pure solvents consisting only of one substance but encompasses also mixtures of pure solvents.

As mentioned before, the invention proposes to overcome the aforementioned difficulties to study materials by DNP NMR Spectroscopy. The invention is thus based on a method to determine the efficiency of a solvent to impregnate or dissolve a sample material for use in a dynamic nuclear polarization (DNP) nuclear magnetic resonance (NMR) experiment, characterized in that the method comprises:
- selecting a non-aqueous solvent,
- providing a polarizing agent that is soluble in the non-aqueous solvent
- dissolving the polarizing agent in the non-aqueous solvent,
- impregnating or dissolving the sample material with the non-aqueous solvent containing the polarizing agent,
- performing a DNP NMR experiment on the impregnated sample material,
- determining a DNP enhancement factor of the DNP NMR experiment.

According to a non-limitative particularity of the method of the invention, the sample material is nanoporous and contains mesopores on a scale ranged between 0,5 nm and 25 nm, preferentially ranged between 0,7 nm and 20 nm, and ideally ranged between 1 nm and 10 nm.

The determined mixture for the dissolution and/or the wetting of materials used for DNP NMR Spectroscopy has a vapor pressure low enough to allow the wetness impregnation of materials without drying out at room temperature. To this end, usually the boiling point of the determined solvent or mixture will be well above room temperature, e.g. above 310K or 320K. However, it is also possible to use solvents with a much lower boiling point down to e.g. 200K or 190K (for example Freon or Freon -like solvents) if special care is taken to prevent drying out of the impregnated sample material.

The solvents employed in the mixture should be chemically compatible with the studied materials and the polarizing agents.

Additionally, the solvent and/or the mixture is selected such that its freezing point is high enough to allow simultaneous freezing with the solid sample material in the same temperature range below room temperature, preferably with a freezing point higher than 150 K. Thus, the mixture should have a freezing point which is high enough to allow freezing below 150 K. When frozen, the ¹H nuclei of the mixture should experience intermolecular nuclear dipolar couplings which enable polarization to be efficiently relayed through the sample.

Moreover, the mixture of the invention is characterised in that it is non-aqueous and chemically compatible toward the studied materials. Such mixture provides several advantages for DNP NMR Spectroscopy. Indeed, the mixture of the invention does not degrade the studied materials. This chemical compatibility of the mixture components avoids erroneous results.

Wetting or solubilisation of materials by the mixture implies that the mixtures are able to wet and impregnate the materials before the introduction of this sample into the spectroscopy device. This procedure is commonly performed at room temperature. To ease this step, it is better that the mixture exists as a liquid at room temperature. The wetting operation is thus performed in optimized conditions.

Further, the mixture of the invention has the ability to improve or enhance the spectroscopy signal if when frozen, the ¹H nuclei of the mixture experience inter-molecular nuclear dipolar couplings which enable polarization to be efficiently relayed through the sample. Such dipolar couplings facilitate a large enhancement of the measured spectroscopy signal. This dipolar coupling network may be enhanced because of non-aqueous solvent is selected such that it contains at least one halogen as part of its chemical structure. The presence of halogen in the chemical structure of the solvents has a favourable effect on the polarization transfer efficiency of the mixtures.

According to a preferred, but non-limitative, feature of the invention, the at least one halogen part of the chemical structure of the non-aqueous solvent is a chlorine or bromine.

According to a non-limitative particularity, the mixture of the invention has a freezing point high enough to be frozen at a similar range of temperature as when the DNP enhancements are performed. Such DNP enhancements are usually performed at temperature comprised in the range of 1mK to 250 K, and preferentially comprised in the range of 1 mK to 200 K. Thus, the mixture should have a freezing point which is high enough to allow freezing below these temperature levels. In such conditions, it is necessary that the materials studied be frozen with its wetting solvent, in order to perform measures in optimized conditions. When frozen, the ¹H nuclei of the mixture should experience intermolecular nuclear dipolar couplings which enable polarization to be efficiently relayed through the sample.

One purpose of the invention is to provide a mixture for the study of materials samples by Dynamic Nuclear Polarization (DNP) Nuclear Magnetic Resonance (NMR). Such mixtures are characterised in that the mixture comprises at least one polarization agent mixed with at least one non-aqueous solvent.

According to a non-limitative particularity of the invention, the mixture is characterized in that the polarizing agent is formed by at least one biradical. As an example, such biradical could be bTbK or TOTAPOL. The mixture of solvent and polarizing agent is preferably carried out with a range of solution concentration between 0.1 mM and 100 mM, and preferably in the range from 5 to 20 mM.

Further the invention concerns a method to perform solid state Dynamic Nuclear Polarization (DNP) Nuclear Magnetic Resonance (NMR) experiments on a sample material characterized in that the method uses a determined solvent and/or a mixture according to the invention.

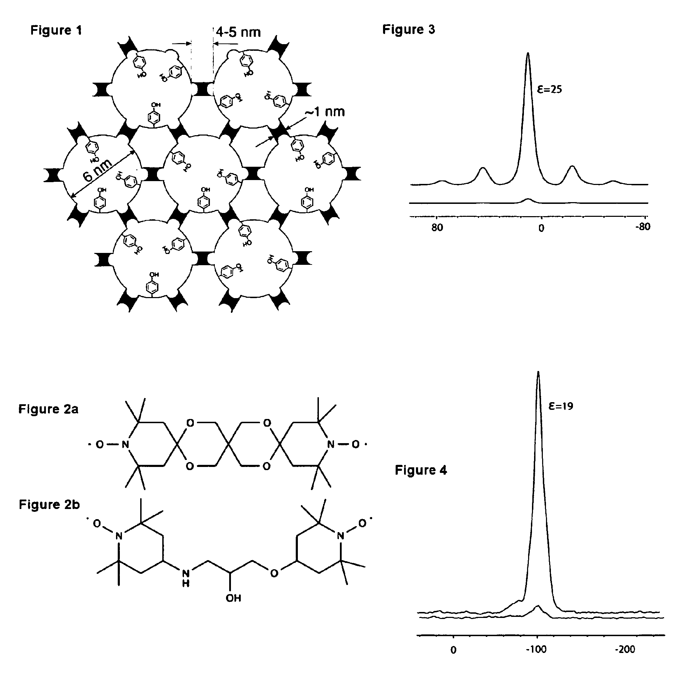

An example to carry out the method to determine the efficiency of a solvent and to obtain the results shown by figures 3 and 4 is detailed as follow.

All the solvents were tested for DNP efficiency on a model hybrid mesoporous material containing surface phenolic groups, named compound I. The structure of the material is depicted in Figure 1. A total of 20 solvents are evaluated under DNP conditions using bTbK as a polarizing agent. This biradical is more soluble in organic solvents than TOTAPOL and has been reported to yield better enhancements in water than TOTAPOL at the same concentration. The structure of these two biradical molecules is respectively shown in Figures 2a and 2b.

The solvents used for this study are based according to the original combination of a number of criteria. First, they should be chemically inert at room temperature on a short time scale towards both the radical and the material (i.e. they should not damage the polarizing agent or the material). The vapor pressure of the solvent at room temperature should be relatively low, to be able to properly wet the sample. One requirement for the DNP NMR experiment is to freeze the solution containing the radical to form a rigid solid in order to allow efficient spin diffusion among solvent molecules. The experiments are conducted here at around 100 K. It is a well known that solvents confined in meso/micro-pores have depressed freezing points in comparison to bulk solvents. Therefore most of the solvents are chosen to have a relatively high freezing point (i.e. above 150 K).

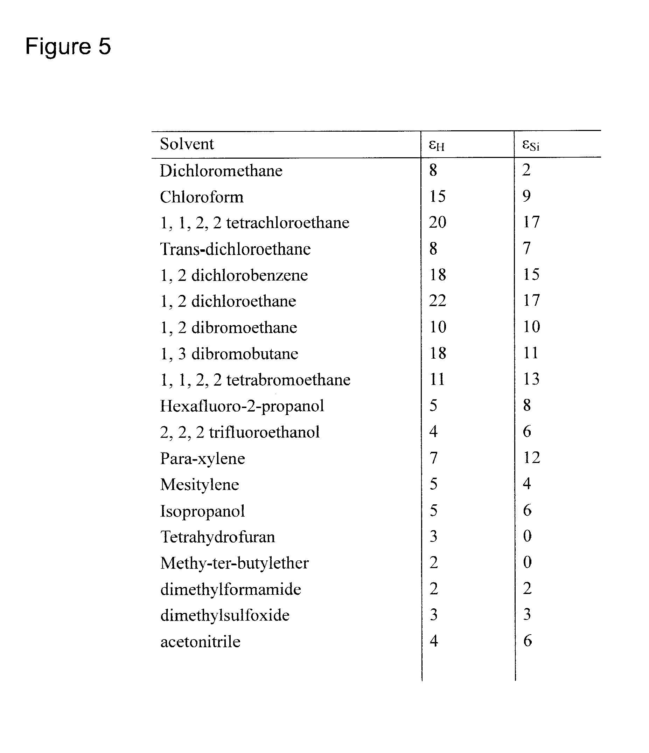

Figure 5 displays the observed proton and silicon enhancements (*ε*) that can be obtained for 20 different solvents. Large discrepancies within this set of solvents can be observed. The solvents found using the criteria above display the best performances and are halogenated solvents, with proton and silicon enhancements ranging from respectively 11 to 22, and from 11 to 17. In addition, reasonable values of ε are obtained with para-xylene. The other solvents display poor or no enhancement under the experimental conditions used in this study.

It can be noted that the presence of the halogens will also reduce the proton density of the solvent, thus concentrating polarization onto a smaller proton spin bath, which could explain their high efficiency under DNP conditions.

From this study, 1,1,2,2 tetrachloroethane in combination with bTbK appears to be one among others of the most promising non aqueous mixtures for DNP SENS. All the following experiments were done using this combination of solvent and radical.

Figure 6 presents the evolution of ε, Σ and Σ_{LT} with the radical concentration for this mixture. As expected, Σ_{LT} is always lower than ε. The optimal concentration is found to be 14.8mM for ε and 10.8 mM for Σ and Σ_{LT}. Under these optimal conditions, an effective sensitivity enhancement Σ_{LT} of 12 is observed, which translates into Σ = 36 when taking into account the Boltzmann factor.

Figure 7 displays the evolution of ε and Σ_{LT} with the deuteration level of the solvent. It is believed that deuteration of the solvent is necessary to reduce the proton spin bath and thus channel more efficiently the polarization to the protons that will contribute to CP. In the present case, it is found that ε peaks at around 30% deuteration for tetrachloroethane, which roughly corresponds to the proton to electron ratio of 90% deuterated water.

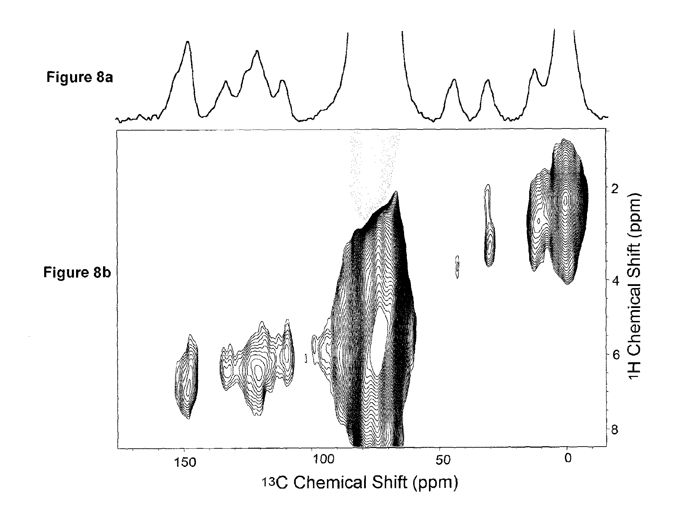

Finally Figures 8a and 8b display a two-dimensional carbon-proton correlation spectrum recorded on a water-sensitive surface organometallic compound, YDEAS grafted on silica. This spectrum was acquired in 1,1,2,2 tetrachloroethane with 10.8 mM bTbK in 10.6 hours. In addition to the large solvent correlation peak, all the expected cross-peaks corresponding to the grafted species are observed in this 2D map. This is the first application of SENS by DNP to a water-sensitive material.

Consequently DNP experiments can be performed using non-aqueous solvents, easily determinable due to the method of the invention. It has been found that fully protonated solvents give the best effective sensitivity enhancements in our systems, and that the best non-aqueous solvents perform with efficiency similar to that of water. Furthermore, the application of these solvents to DNP is not limited to solid-state experiments. Dissolution DNP can benefit from the use of such solvents, as molecules that are not compatible with water can now be used.

The introduction of these solvents for DNP opens the way to the use of new biradicals for DNP, as solubility in water is often the limiting factor for their application for DNP.

The present invention is of course not limited to the preferred embodiments described and represented herein, changes can be made or equivalents used without departing from the scope of the invention.

## Claims

1. A method to determine the efficiency of a solvent to impregnate or dissolve a sample material for use in a dynamic nuclear polarization (DNP) nuclear magnetic resonance (NMR) experiment, **characterized in that** the method comprises:
- selecting a non-aqueous solvent,
- providing a polarizing agent that is soluble in the non-aqueous solvent,
- dissolving the polarizing agent in the non-aqueous solvent,
- impregnating or dissolving the sample material with the non-aqueous solvent containing the polarizing agent,
- performing a DNP NMR experiment on the impregnated sample material,
- determining a DNP enhancement factor of the DNP NMR experiment.

2. A method to obtain a DNP-enhanced NMR spectrum of a sample material, **characterized in that** the method comprises:
- using a mixture of a solvent and a polarizing agent,
- selecting a non-aqueous solvent,
- providing a polarizing agent that is soluble in the non-aqueous solvent,
- dissolving the polarizing agent in the non-aqueous solvent,
- impregnating or dissolving the sample material with the non-aqueous solvent containing the polarizing agent,
- performing a DNP NMR experiment on the impregnated sample material.

3. A method according to claim 2, **characterized in that** the used mixture is selected according to claim 1.

4. A method of use of a mixture of a non-aqueous solvent and a polarizing agent that is soluble in the non-aqueous solvent to impregnate or dissolve a sample material in order to perform a dynamic nuclear polarization (DNP) nuclear magnetic resonance (NMR) experiment **characterized in that** the DNP NMR is performed by a method according to claim 2 or claim 3 on said impregnated or dissolved sample.

5. A method according to one of claims 1 to 4, **characterized in that** the sample material is solid at room temperature.

6. A method according to claim 5, **characterized in that** the sample material is solid that contains mesopores on a scale between 0,5 nm and 25 nm.

7. A method according to one of the previous claims, **characterized in that** the non-aqueous solvent is selected such that it contains at least one heteroatom, preferably a halogen, as part of its chemical structure.

8. A method according to claim 7, **characterized in that** the non-aqueous solvent is selected such that it contains at least one chlorine atom or bromine atom as part of its chemical structure.

9. A method according to one of the previous claims, **characterized in that** the non-aqueous solvent is selected such that its boiling point is high enough to prevent drying out of an impregnated sample material.

10. A method according to one of the previous claims, **characterized in that** the non-aqueous solvent is selected such that its freezing point is high enough to allow simultaneous freezing with the solid sample material in the same temperature range below room temperature.

11. A method according to one of the previous claims, **characterized in that** the non-aqueous solvent is selected such that it provides efficient spin diffusion.

12. A method according to one of the previous claims, **characterized in that** the polarizing agent comprises biradicals.

13. A method according to claim 12, **characterized in that** the polarizing agent is formed by bTbK and/or TOTAPOL.

14. A method according to one of the previous claims, **characterized in that** the non-aqueous solvent comprises at least one of the element of the compounds list including: dichloromethane, chloroform, 1, 1, 2, 2 tetrachloroethane, 1, 1, 1 trichloroethane, trans-dichloroethane, 1, 2 dichlorobenzene, 1, 2 dichloroethane, 1, 2 dibromoethane, 1, 3 dibromobutane, 1, 1, 2, 2 tetrabromoethane, hexafluoro-2-propanol, 2, 2, 2 trifluoroethanol para-xylene, mesitylene, isopropanol, tetrahydrofuran, methy-ter-butylether, dimethylformamide, dimethylsulfoxide andacetonitrile.

15. A method according to one of the previous claims, **characterized in that** the radical concentration of the polarizing agent in the non-aqueous solvent is in the range from 0.1 to 100 mM.
